# EUROPEAN PATENT SPECIFICATION

(11) **EP 1 566 422 B1**
(45) Date of publication and mention of the grant of the patent: **10.01.2007**
(21) Application number: 03772849.0
(22) Date of filing: 18.11.2003
(51) Int. Cl.: C09J 4/00, C09J 163/10, C08F 2/50, G11B 7/24

(54) **UV-CURE ADHESIVE COMPOSITION FOR OPTICAL DISK, CURED MATERIAL AND GOODS**
UV-HÄRTBARES KLEBEMITTEL FÜR OPTISCHE SPEICHERMEDIEN, GEHÄRTETES MATERIAL UND WAREN
COMPOSITION ADHESIVE POLYMERISABLE PAR UV POUR DISQUE OPTIQUE, MATIERE ET ARTICLES TRAITES

(30) Priority: 26.11.2002 JP 2002342037
(43) Date of publication of application: 24.08.2005
(73) Proprietor: NIPPON KAYAKU KABUSHIKI KAISHA, Tokyo 102-8172 (JP)
(72) Inventor: MIZUTANI, Go c/o NIPPON KAYAKU KABUSHIKI KAISHA, Shimo 3-chome, Kita-ku, Tokyo 115-8588 (JP); TOKUDA, Kiyohisa c/oNIPPON KAYAKU KABUSHIKI KAISHA, Shimo 3-chome Kita-ku, Tokyo 115-8588 (JP); ISHII, Kazuhiko, Kawagoe-shi, Saitama 350-1108 (JP)
(74) Representative: Gille Hrabal Struck Neidlein Prop Roos
(86) International application number: PCT/JP2003/014644
(87) International publication number: WO 2004/048490

(56) References cited:
- EP-A- 0 177 791
- EP-A- 0 359 373
- EP-A- 0 989 173
- EP-A1- 0 768 353
- WO-A1-00/09620
- WO-A1-98/36325
- JP-A- 8 325 523
- JP-A- 8 325 524
- JP-A- 8 325 526
- JP-A- 11 286 657
- JP-A- 2001 049 198
- JP-A- 2002 092 961
- JP-A- 2002 114 949
- JP-A- 2002 256 228
- US-A- 4 525 258
- US-A- 5 484 864

## Description

### Technical Field

The present invention relates to an adhesive composition for an optical disk, in particular, a UV-curable adhesive composition for bonding two disk substrates and allowing the substrates to adhere with curing with ultraviolet rays as is typical for DVDs, and a bonded optical disk obtained by using the same.

### Background Art

DVDs in practical use at present, which are bonded optical disks, can be roughly classified into DVD-ROMs on which information such as movies has been recorded when producing the disk and blank DVDs on which no information is recorded upon production allowing consumers themselves to record information on the pigment recording layer or the inorganic recording layer. DVD-ROMs include DVD-5 with a recording layer structure of single-sided, single layer read having a recording capacity of about 5 GB, DVD-9 of a single-sided, dual layer read having a recording capacity of about 9 GB, DVD-10 of a double-sided, dual layer read having a recording capacityof about 10GB, and DVD-18 of a double-sided, quadruple layer read having a recording capacity of about 18 GB. At present, DVD-9s are most commonly used because of their recording capacity for recording a movie of about two and a half hours. Presently, DVD-9s using an aluminum alloy as a total reflection film and gold as a translucent reflection film are most common. Unlike a total reflection film, a translucent reflection film must transmit laser, and so the film needs to be thin. Thus, gold, which can be easily formed into a thin film and is relatively stable, has been conventionally used.

Gold, however, is very expensive and therefore the material for a translucent reflection film has been shifted from gold to silicon or a silicon compound, and further to silver or a silver alloy. In addition, use of blue lasers is now being developed for further increase of recording capacity. While red lasers do not have any problem of laser transmittance even if the material for the translucent reflection film is gold, silicon, a silicon compound, silver or a silver alloy, it has been recognized that for blue lasers, silver or a silver alloy is effective as the material for a translucent reflection film in view of the transmittance at about 400 nm which is the wavelength of the blue laser. Silver and silver alloys, however, has a disadvantage that they are more susceptible to oxidation and unstable than gold. When a thin film of silver or a silver alloy is used for a translucent reflection film and is allowed to adhere with a conventional adhesive for a bonded optical disk, a durability equivalent to those of bonded optical disks in which gold is used as a material for the translucent reflection film cannot be afforded, and an adhesive having a satisfactory durability has not been provided yet.

On the other hand, in the field of blank DVDs, there are various formats including DVD-R, DVD+R, DVD-RW, DVD+RW, and DVD-RAM. Presently dominant DVD-R, DVD-RAM, DVD+R and DVD+RW are of single-sided, single layer structure, in which silver or a silver alloy having a high reflectance, as well as an aluminum compound, is used as a material for a reflection film. However, because silver or a silver alloy is subject to oxidation, a protective coat must be formed. Although formation of the protective coat has an advantage of achieving a high durability, it has involved problems such as decrease of production efficiency of optical disks, increase of production cost and decrease of production yield. For such reason, development of an adhesive which can afford a durability equivalent to those of conventional optical disks without forming a protective coat has been desired.

The present inventors have conducted intensive studies and as a result, have developed an adhesive which can impart durability as high as that of a conventional optical disk using gold as a translucent reflection film, even to a bonded optical disk obtained by adhering a translucent reflection film comprising silver or a silver alloy, as described in Japanese Patent Application Laying Open (KOKAI) No. 2002-265885. However, although these adhesives can afford a somewhat high durability, two problems were left unsolved. The first problem is generation of voids (air bubbles) when bonding two optical disk substrates by an optical disk manufacturing apparatus. This problem was mostly found in DVDs of single-sided, single layer read type such as DVD-5s and blank DVDs. The second is a problem of degradation in reflectance of the silver or a silver alloy translucent reflection film when a bonded optical disk using silver or a silver alloy translucent reflection film is exposed to sunlight for a long time.

The mechanism for preventing voids in optical disk manufacturing apparatuses which is widely employed in the industry of DVD production as seen in Japanese Patent Application Laying Open (KOKAI) No. 2001-60344, for example, utilizes a characteristic that the adhesive used in the mechanism has high electrical conductivity. Most of adhesives for optical disks using gold, silicon or a silicon compound as a translucent reflection film have an electrical resistance of 1000 MΩ·cm or less, and highly conductive, and thus voids were hardly introduced into DVDs manufactured by the aforementioned optical disk manufacturing apparatus. However, along with the shift of the material for the translucent reflection film to a silver or a silver alloy which is highly susceptible to oxidation, adhesive components used for the material also shifted toward low concentration of ions and rendering the components hydrophobic. Adhesives for silver or a silver alloy reflection film presently used thus have a high electrical resistance, and for example, when manufacturing DVDs, in particular, single-sided, single layer read-only DVDs by the aforementioned apparatus, there is a problem that because no metal reflection film is provided on a substrate where recording is not conducted, applied voltage of the aforementioned apparatus cannot afford electric current sufficient to prevent generation of voids and as a result, voids are easily generated.

In addition, degradation in reflectance of the translucent reflection film due to long time exposure to sunlight is a phenomenon occurring only when silver or a silver alloy is used for the translucent reflection film, which does not occur when the material for the translucent reflection filmisgold, silicon or a silicon compound. Thus, a UV-curable resin composition for bonding an optical disk capable of suppressing degradation in reflectance even in the case of using silver or a silver alloy for a translucent reflection film has been demanded.

Thermosetting pressure-sensitive adhesives are described in EP -A- 0 989 173. These adhesives contain an alkyl (meth)acrylate and an epoxy compound. UV curable adhesive compositions are described in US -A- 5,484,864 which comprise a photopolymerization initiator and an epoxy methacrylate derivative. Primer coating compositions are described in EP -A- 0 177 791 which contain an epoxy(meth)acrylate compound and a monofunctional methacrylate, optionally a monofunctional (meth)acrylate with a hydroxy group is present.

### Problems to be Solved by the Invention

The present invention aims at providing an adhesive which exhibits, in a bonded optical disk obtained by adhering a translucent reflection film comprising silver or silver alloy, a high durability equivalent to those of conventional optical disks in which gold is used for a translucent reflection film, and providing a UV-cure adhesive which is free of inclusion of voids when bonding by an optical disk manufacturing apparatus, and which can suppress degradation in reflectance even if an optical disk obtained by bonding is exposed to sunlight for a long time.

### Means for Solving the Problems

The present inventors of the present invention have conducted intensive studies to solve the above-mentioned problem and as a result, have found that by bonding a translucent reflection film comprising silver or a silver alloy by using a UV-cure adhesive having a specific composition, voids are not generated when bonding by an optical disk manufacturing apparatus, high durability of an optical disk obtained by bonding can be achieved, and the degradation in reflectance of the translucent reflection film of an optical disk obtained by bonding can be suppressed, which resulted in the completion of the present invention.

Accordingly, the present invention relates to
(1) a UV-curable resin composition for bonding substrates of an optical disk, one or both of which have a total reflection film or a translucent reflection film comprising silver or a silver alloy, characterized in that the UV-curable resin composition comprises, as essential components, an epoxy (meth) acrylate (A), 2,2-dimethoxy-1,2-diphenylethan-1-one, a mono- to trifunctional (meth) acrylate monomer (E) other than (A), a monofunctional (meth) acrylate compound (C) containing a hydroxyl group and a (meth) acrylate phosphate compound (D);
(2) the UV-curable resin composition according to (1), wherein the mono- to trifunctional (meth) acrylate monomer (E) is dicyclopentanyl di(meth) acrylate;
(3) the UV-curable resin composition according to (1), wherein the mono- to trifunctional (meth) acrylate monomer (E) is hydroxypivalic acid neopentyl glycol di(meth) acrylate.;
(4) the UV-curable resin composition according to any one of (1) to (3), which has an electrical resistivity of 1000 MΩ·cm (MΩ = 10⁶ Ω) or less at 25°C;
(5) a bonded optical disk in which two disk substrates are allowed to adhere with a UV-curable resin composition according to any one of (1) to (4).

The present invention is described in detail.

The UV-cure resin composition for bonding an optical disk of the present invention contains, as essential components, an epoxy (meth)acrylate (A), 2,2-dimethoxy-1,2-diphenylethan-1-one and a mono- to trifunctional (meth) acrylate monomer (E). The UV-cure resin composition for bonding an optical disk of the present invention further contains, as an optional component, a mono (meth) acrylate compound (C) containing a hydroxyl group, a (meth)acrylate phosphate compound (D), and optionally a urethane(meth)acrylate (F) and an additive (G). In the following, the essential components and the optional components in the UV-cure resin composition for bonding an optical disk of the present invention are each described. In the present invention, (meth) acrylate means methacrylate or acrylate.

The epoxy (meth)acrylate (A) in the present invention has a function to improve the curability and the hardness of the cured product, as well as to decrease the electrical resistivity of a UV-cure resin composition and to suppress degradation in reflectance when the optical disk bonded by using the resin composition of the present invention is exposed to sunlight for a long time. In the present invention, as the epoxy (meth) acrylate (A), any compound can be used as long as it is obtained by reacting a glycidyl ether epoxy compound and (meth)acrylic acid. Examples of the glycidyl ether epoxy compound for preparing epoxy (meth)acrylate preferably used in the present invention include diglycidyl ether of bisphenol A or an alkylene oxide adduct thereof, diglycidyl ether of bisphenol F or an alkylene oxide adduct thereof, diglycidyl ether of hydrogenated bisphenol A or an alkylene oxide adduct thereof, diglycidyl ether of hydrogenated bisphenol F or an alkylene oxide adduct thereof, ethylene glycol diglycidyl ether, propylene glycol diglycidyl ether, neopentyl glycol diglycidyl ether, butanediol diglycidyl ether, hexanediol diglycidylether, cyclohexane dimethanol diglycidyl ether and polypropylene glycol diglycidyl ether.

The epoxy (meth)acrylate (A) used in the present invention is obtained by reacting such glycidyl ether epoxy compound with (meth)acrylic acid under, for example, the following conditions.

Based on 1 equivalent of epoxy group of the glycidyl ether epoxy compound, 0.9 to 1.5 moles, more preferably 0.95 to 1.1 moles of (meth)acrylic acid is reacted. The reaction temperature is preferably 80 to 120°C, and the reaction time is about 10 to 35 hours. To facilitate the reaction, a catalyst such as triphenylphosphine, triethanolamine and tetraethylammonium chloride is preferably used. In addition, to prevent polymerization during the reaction, a polymerization inhibitor (e.g. paramethoxyphenol, methylhydroquinone) may be used.

In the present invention, bisphenol A epoxy (meth) acrylate obtained from a bisphenol A epoxy compound is more preferably used. In the present invention, the molecular weight of the epoxy (meth)acrylate (A) is preferably 500 to 10000.

The above-mentioned epoxy (meth)acrylate (A) may be used alone or in a mixture of two or more. The content of the epoxy (meth)acrylate (A) in the composition is usually 1 to 50 % by weight, and preferably 5 to 40% by weight.

2,2-dimethoxy-1,2-diphenylethan-1-one contained in the UV-cure resin composition for bonding an optical disk of the present invention acts as a photopolymerization initiator. By using 2,2-dimethoxy-1,2-diphenylethan-1-one as a photopolymerization initiator, the degradation in reflectance of a silver or a silver alloy reflection film after a disk obtained by bonding is exposed to sunlight for a long time can be suppressed.

The content of the 2,2-dimethoxy-1,2-diphenylethan-1-one in the composition is usually 0.5 to 20% by weight, and preferably 1 to 10% by weight. 2,2-dimethoxy-1,2-diphenylethan-1-one is readily available on the market.

In the present invention, other photopolymerization initiators may be used together as a photopolymerization initiator where necessary. Specific examples of the photopolymerization initiator which may be used together include 1-hydroxycyclohexyl phenyl ketone, 2-hydroxy-2-methyl-1-phenylpropan-1-one, 1-[4-(2-hydroxyethoxy)-phenyl]-2-hydroxy-2-methyl-1-propa n-1-one, 2-methyl-[4-(methylthio)phenyl]-2-morpholino-1-propanone, 2-benzyl-2-dimethylamino-1-(4-morpholinophenyl)-butan-1-o ne, 2-chlorothioxanthone, 2,4-dimethylthioxanethone, 2,4-diisopropylthioxanthone, isopropylthioxanthone, 2,4,6-trimethylbenzoyldiphosphine oxide and bis(2,6-dimethoxy-benzoyl)-2,4,4-trimethylpentylphosphine oxide. The photopolymerization initiator may be used alone or in a mixture of two or more. The content thereof in the composition is usually 0.005 to 5% by weight, and preferably 0.01 to 3% by weight. The content is usually 0.1 to 50% by weight, and preferably 0.1 to 30% by weight based on 2,2-dimethoxy-1,2-diphenylethan-1-one.

In addition, a photopolymerization accelerator such as amines may also be used together. Specific examples of the photopolymerization accelerator include 2-dimethylaminoethyl benzoate, dimethylaminoacetophenone, ethyl p-dimethylaminobenzate and isoamyl p-dimethylaminobenzoate. The content of the photopolymerization accelerator in the composition is usually 0.005 to 5% by weight, and preferably 0.01 to 3% by weight.

The UV-cure resin composition for bonding an optical disk of the present invention may contain a mono- to trifunctional (meth)acrylate monomer (E). By using the mono- to trifunctional (meth)acrylate monomer (E), the monofunctional (meth)acrylate monomer functions to improve the adhesion, while the di- and trifunctional (meth)acrylate monomers function to improve the durability of the optical disk obtained by bonding. Specific examples of the monofunctional (meth) acrylate monomer that can be used include tricyclodecane (meth)acrylate, dicyclopentadieneoxyethyl (meth)acrylate, dicyclopentanyl (meth)acrylate, isoboronyl (meth)acrylate, adamantyl (meth)acrylate, phenyloxyethyl (meth)acrylate, phenoxypolyethyleneglycol (meth)acrylate, benzyl (meth)acrylate, tetrahydrofurfuryl (meth)acrylate, morpholine (meth)acrylate, 2-hydroxypropyl (meth)acrylate, lauryl (meth)acrylate, isodecyl (meth)acrylate, stearyl (meth)acrylate, isooctyl (meth)acrylate, tridecyl (meth)acrylate and ethoxydiethylene glycol (meth)acrylate. Specific examples of the di- and trifunctional (meth) acrylate monomers include neopentyl glycol di(meth)acrylate, hydroxypivalic acid neopentyl glycol di(meth)acrylate, polyethylene glycol di(meth)acrylate, dicyclopentanyl di(meth)acylate, 1,6-hexanediol di(meth)acrylate, polypropylene glycol di(meth)acrylate, ethylene oxide modified bisphenol A di(meth)acrylate, ethylene oxide modified trimethylolpropane tri(meth)acrylate, ethylene oxide modified pentaerythritol tetra(meth)acrylate, tris[(meth)acryloxyethyl]isocyanurate and ethylene oxide modified dipentaerythritol hexa(meth)acrylate. Of the mono-to trifunctional (meth)acrylate monomers (E), particularly preferred are dicyclopentanyl di(meth)acrylate and hydroxypivalic acid neopentyl glycol di(meth) acrylate. The mono- to trifunctional (meth) acrylate monomer (E) may be used alone or in a mixture of two or more. The content of the mono-to trifunctional (meth) acrylate monomer (E) in the composition is usually 30 to 98.5% by weight, and preferably 31 to 70% by weight.

A monofunctional (meth) acrylate (C) containing a hydroxyl group is contained in the UV-cure resin composition for bonding an optical disk of the present invention. Specific examples of the monofunctional (meth)acrylate (C) containing a hydroxyl group include 2-hydroxyethyl (meth) acrylate, 2-hydroxypropyl (meth)acrylate, 2-hydroxybutyl (meth)acrylate, 4-hydroxybutyl (meth)acrylate, dipropylene glycol (meth)acrylate, polypropylene glycol (meth)acrylate, caprolactone acrylate and aliphatic epoxy acrylate. Of these, preferred are dipropylene glycol (meth)acrylate and polypropylene glycol (meth)acrylate, and particularly preferred are 4-hydroxybutyl (meth)acrylate and 2-hydroxypropyl (meth)acrylate. The component (C) may be used alone or in a mixture of two or more. The content of the component (C) in the composition is usually 1 to 70% by weight, and preferably 1 to 50% by weight.

It functions to decrease the electrical resistance of the UV-cure resin composition, but too high a content is not preferable because silver or a silver alloy may be corroded.

The UV-cure resin composition for bonding an optical disk of the present invention further contains a (meth)acrylatephosphate compound (D). The (meth)acrylate phosphate compound (D) has a function to improve adhesion, in particular, adhesion to an aluminum alloy, silver or a silver alloy, but too high a content is not preferable because silver or a silver alloy may be corroded. The (meth) acrylate phosphate compound (D) may be a monoester, diester or triester as long as it is a (meth)acrylate having a phosphoric ester structure. Specific examples of the (meth)acrylate phosphate compound (D) include ethylene oxide modified phenoxide (meth) acrylate phosphate, ethylene oxide modified butoxide (meth)acrylate phosphate, ethylene oxide modified octyl oxide (meth)acrylate phosphate, ethylene oxide modified di(meth)acrylate phosphate and ethylene oxide modified tri(meth)acrylate phosphate. The (meth)acrylatephosphate (D) may be used alone or in a mixture of two or more. The content of the (meth)acrylate phosphate (D) in the composition is usually 0.005 to 5% by weight, and preferably 0.05 to 3% by weight.

The UV-cure resin composition for bonding an optical disk of the present invention may contain a urethane (meth) acrylate (F) where necessary. The urethane (meth)acrylate (F) has a function to improve the mechanical properties (warping, deformation, etc.) of optical disks bonded using the UV-cure resin composition of the present invention. However, too high a content is not preferable because the reflectance tends to decrease easily when an optical disk bonded by using the UV-cure resin composition of the present invention is exposed to sunlight for a long time. The urethane (meth)acrylate (F) is obtained by reacting polyhydric alcohol, organic polyisocyanate and a hydroxy (meth)acrylate compound.

Examples of polyhydric alcohol include neopentyl glycol, 3-methyl-1,5-pentanediol, ethyleneglycol, propyleneglycol, 1,4-butanediol, 1,6-hexanediol, trimethylolpropane, pentaerythritol, tricyclodecane dimethylol and bis-[hydroxymethyl]-cyclohexane, polyesther polyols obtained by the reaction of the polyhydric alcohol and a polybasic acid (e.g. succinic acid, phthalic acid, hexahydrophthalic anhydride, terephthalic acid, adipic acid, azelaic acid and tetrahydrophthalic anhydride), caprolactone alcohols obtained by the reaction of polyhydric alcohol and ε-caprolactone, polycarbonate polyols (e.g. polycarbonate diols obtained by the reaction of 1,6-hexanediol and diphenylcarbonate) and polyether polyols (e.g. polyethylene glycol, polypropylene glycol, polytetramethylene glycol, ethylene oxide modified bisphenol A). Examples of organic polyisocyanate include isophorone diisocyanate, hexamethylene diisocyanate, tolylene diisocyanate, xylene diisocyanate, diphenyl methane-4,4'-diisocyanate and dicyclopentanyl isocyanate.

Examples of the hydroxy(meth)acrylate compound include hydroxyethyl (meth)acrylate, hydroxypropyl (meth)acrylate, hydroxybutyl (meth)acrylate, dimethylolcyclohexylmono (meth)acrylate and hydroxycaprolactone (meth)acrylate.

The reaction is conducted, for example, as follows. That is, organic polyisocyanate is mixed to polyhydric alcohol so that the amount of the isocyanate group is 1.1 to 2.0 equivalents per 1 equivalent of the hydroxyl group, and the reaction is conducted at a reaction temperature of preferably 70 to 90°C to synthesize a urethane oligomer. Then a hydroxy(meth)acrylate compound is added so that the amount of the hydroxyl group is preferably 1 to 1.5 equivalents per 1 equivalent of the isocyanate group of the urethane oligomer, and the reaction is conducted at a reaction temperature of 70 to 90°C to give an objective urethane (meth) acrylate. The molecular weight of the urethane (meth)acrylate (F) is preferably 400 to 10000. The urethane (meth)acrylate (F) may be used alone or in a mixture of two or more. The content of the urethane (meth)acrylate (F) in the composition is usually 1 to 20% by weight, and preferably 5 to 15% by weight.

The UV-cure resin composition for bonding an optical disk of the present invention may contain an additive (G) for storage stability or other purposes. Examples of the additive (G) that can be used include a phenol compound, an amine compound, a sulfur compound and a phosphorus compound.

Of these, specific examples of the phenol compound include 2,6-di-tert-butyl-4-methylphenol, 2,2'-methylene-bis(4-methyl-6-tert-butylphenol), 2,2'-methylene-bis(4-ethyl-6-tert-butylphenol), 4,4'-thio-bis(3-methyl-6-tert-butylphenol), 4,4'-butylidene-bis(3-methyl-6-tert-butylphenol), triethylene glycol-bis[3-(3-tert-butyl-5-methyl-4-hydroxyphenyl)propi onate], 1,6-hexanediol-bis[3-(3,5-di-tert-butyl-4-hydroxyphenyl)p ropionate], 2,2-thio-diethylene bis[3-(3,5-di-tert-butyl-4-hydroxyphenyl)propionate], octadecyl-3-[3,5-di-tert-butyl-4-hydroxyphenyl]propionate, 3,5-di-tert-butyl-4-hydroxybenzyl phosphonate-diethyl ester, 1,3,5-trimethyl-2,4,6-tris(3,5-di-tert-butyl-4-hydroxyben zyl benzene and isooctyl-3-(3,5-di-tert-butyl-4-hydroxyphenyl)propionate.

Specific examples of the amine compound include octylated diphenylamine(4,4'-dioctyl-diphenylamine), 4,4'-dicumyl-diphenylamine, 6-ethoxy-2,2,4-trimethyl-1,2-dihydroquinoline, 2,2,4-trimethyl-1,2-dihydroquinoline polymer and ADKSTAB LA-82 (available from Asahi Denka Co., Ltd.). Specific examples of the sulfur compound include 2-mercaptobenzimidazole, 2,4-bis[(octylthio)methyl]-o-cresol, 2,4-bis-(n-octylthio)-6-(4-hydroxy-3,5-di-tert-butylanili no) -1, 3, 5-triadine and ADKSTAB AO-412S (available from Asahi Denka Co., Ltd.). Specific examples of the phosphorus compound include tris(nonylated phenyl) phosphite, ADKSTAB PER-4C (available from Asahi Denka Co., Ltd.), ADKSTAB 260 (available from Asahi Denka Co., Ltd.) and ADKSTAB 522A (available from Asahi Denka Co., Ltd.). One or more of the additives may be contained. The content of the additive (G) in the composition is usually 0.005 to 10% by weight, and preferably 0.01 to 5% by weight.

The UV-cure resin composition of the present invention may also contain, as a high molecular polymer, polyester-, polycarbonate-, polyacrylic-, polyurethane- or polyvinyl-based resin. The composition may also contain additives such as an organic solvent, a silane coupling agent, a polymerization inhibitor, a leveling agent, an antistatic agent, a surface lubricant, a ultraviolet absorber and filler, where necessary.

The UV-cure resin composition of the present invention can be obtained by mixing and dissolving each component mentioned above at room temperature to 80°C, and impurities may be removed by filtration where necessary. The viscosity at 25°C of the UV-cure resin composition of the present invention is' preferably in the range of 100 to 5000 mPa·S (measured by a Brookfield type viscometer) in consideration of coating property.

It is preferable to blend the aforementioned chemical agents so that the electrical resistivity at 25°C of the UV-cure resin composition of the present invention falls into the range of 0 to 1000 MΩ·cm, particularly 0 to 600 MΩ·cm. In the present invention, the electrical resistivity was measured by using R8340 ULTRA HIGH RESISTANCE METER made by ADVANTEST Corporation.

Another finding is that when one or both of the optical disk substrates to be bonded are a silver or silver alloy reflection film, it is suitable that the UV-cure resin composition has an electrical resistivity at 25°C of 1000 MΩ·cm or less, preferably 100 to 1000 MΩ·cm, and particularly preferably 100 to 600 MΩ·cm for an optical disk manufacturing apparatus which conducts bonding by applying a voltage. A UV-cure resin composition with such function is prepared by accordingly selecting components from the aforementioned epoxy (meth)acrylate (A), photopolymerization initiator (B), monofunctional (meth) acrylate (C) containing a hydroxyl group, (meth)acrylate phosphate compound (D) and mono- to trifunctional (meth)acrylate monomer (E).

The UV-cure resin composition of the present invention can be suitably used as an adhesive for a bonded optical disk in which silver or a silver alloy is used for a translucent reflection film or a total reflection film. Specifically, the UV-cure resin composition of the present invention is applied by any method such as a spin coating method, a 2P method, a roll coating method and a screen printing method, and two optical disk substrates are bonded so that the film thickness of an adhesive layer is 1 to 100 µm after bonding, and then by irradiating with ultraviolet to near ultraviolet rays from one or both sides, the adhesive layer is cured to bond the substrates. The irradiation amount is preferably 50 to 1000 mJ/cm², particularly preferably 100 to 700 mJ/cm². For curing by irradiation with ultraviolet to near ultraviolet rays, the light source is not particularly limited as long as it is a lamp which can emit ultraviolet to near ultraviolet rays. For example, a low pressure, high pressure or ultra-high pressure mercury lamp, a metal halide lamp, a (pulse) xenon lamp or an electrodeless lamp may be used.

The optical disk to be bonded include those using silver or a silver alloy as a translucent reflection film and silver or a silver alloy as a reflection film, and those using silver or a silver alloy as a total reflection film (for single layer type), and in addition to these, the composition can also be used for those using gold, silicon or a silicon compound as a translucent reflection film and aluminum or an aluminum alloy and silver or a silver alloy as a total reflection film. When used for a single layer type, the UV-cure resin composition of the present invention may be applied onto a total reflection film using silver or silver alloy without forming a protective film to bond a blank substrate (having no reflection film).

The substrate of an optical disk includes total reflection film substrates and translucent reflection film substrates. As a total reflection film substrate, a 0.6 mm thick polycarbonate substrate (hereinafter PC substrate) to which aluminum, an aluminum alloy, silver or a silver alloy is sputtered (deposited) in a film thickness of 35 to 60 nm (nanometer) can be used. As a translucent reflection film, a 0.6 mm thick PC substrate to which gold, silicon or a silicon alloy and silver or a silver alloy are sputtered (deposited) in a film thickness of 5 to 20 nm can be used.

The UV-cure resin composition of the present invention has an excellent effect that, in a bonded optical disk obtained by adhering a translucent reflection film comprising silver or a silver alloy, voids (air bubbles) are not included when bonding by an optical disk manufacturing apparatus, the durability of the obtained optical disk is equivalent to those of optical disks in which gold is used as a translucent reflection film and the degradation in reflectance caused by exposure to sunlight for a long time can be suppressed.

In the present invention, the experiment of long time exposure to sunlight of an optical disk bonded by using the UV-cure resin composition was conducted by using XENON WEATHER-OMETER Ci-4000 made by Atlas Material Testing Technology LLC. The reflectance of silver or a silver alloy translucent reflection film after the experiment was measured by DVD-2000 made by AECO Ltd. For DVD-9, the standard of the reflectance of a translucent reflection film defined in that industry is not less than 18%.

### Examples

In the following, the present invention will be explained in more detail by means of Examples, but the present invention is not limited to these Examples. In Examples, part (s) means "part by weight" unless otherwise noted.

### Example 1

In a reactor equipped with a stirrer and a thermometer, 20 parts of bisphenol A diglycidylether diacrylate (EPA-37) (A), 5 parts of 2,2-dimethoxy-1,2-diphenylethan-1-one (IRGACURE 651), 10 parts of 4-hydroxybutyl acrylate (4HBA) (C), PM-2 (0.1 part)(D), 50 parts of tricyclodecanedimethylol diacrylate (R-684) (E) and 15 parts of phenoxyethyl acrylate (R-561) (E) were mixed and dissolved at 60°C for an hour to give a UV-cure resin composition of the present invention. The obtained UV-cure resin composition of the present invention had a viscosity at 25°C of 460 mPa·s (measured by a Brookfield type viscometer). A bonded optical disk of the present invention was prepared by adhering two substrates using the UV-cure resin composition according to the following procedures 1 to 4.
1. A silver alloy translucent reflection film substrate was prepared by sputtering silver alloy TTP-40A available from Target Technology Company LLC on a 0.6 mm thick PC substrate in an average film thickness of 10 nm. An aluminum alloy total reflection film substrate was prepared by sputtering an aluminum alloy available from Unaxis on a 0.6 mm thick PC substrate in an average film thickness of 45 nm.
2. 2.5 g of the above UV-cure resin composition was supplied to the circumference of the aluminum alloy-sputtered DVD substrate in the form of a circle.
3. The DVD substrate on which a silver alloy reflection film was sputtered was put on the aluminum alloy substrate with the sputtered surface downward, and spin-coating was conducted for 4 seconds at a rate of 2000 rpm to bond them so that the film thickness of the resin composition was 45 to 65 µm. As an optical disk bonding apparatus, an apparatus made by Origin ELECTRIC CO., LTD. (ADF-2HL) was used.
4. By using upper and lower two xenon flash lamps, irradiation of 8 shots at 1800 V was conducted by the upper lamp and irradiation of 4 shots at 1600 V was conducted by the lower lamp to carry out curing and adhesion. In the irradiation process, the DVD disk was positioned with the silver alloy translucent reflection film on the upper side and the aluminum alloy total reflection film on the lower side. Examples 2 to 5, Comparative Example 1

UV-cure adhesive resin compositions of Examples 2 to 5 and Comparative Example 1 were prepared in the same manner as in Example 1. Comparative Example 1 is a supplementary experiment of Example 1 of Japanese Patent Application Laying Open (KOKAI) No. 2002-265885. A bonded optical disk was each prepared in the same manner as in Example 1. The abbreviations of each composition shown in Table 1 are as follows.
UA-732: polyether-based urethane acrylate available from NIPPON KAYAKU CO., LTD.
EPA-37 : bisphenol A diglycidyl ether diacrylate available from NIPPON KAYAKU CO., LTD.
4HBA: 4-hydroxybutyl acrylate available from OSAKA ORGANIC CHEMICAL INDUSTRY LTD.
HPA: hydroxypropyl acrylate available from Kyoei Kagaku Kogyo Kabushiki Kaisha
MANDA: hydroxypivalic acid neopentyl glycol diacrylate available from NIPPON KAYAKU CO., LTD.
BP-4EA: bisphenol A polyethoxy diacrylate available from Kyoei Kagaku Kogyo Kabushiki Kaisha
4EG-A: tetraethylene glycol diacrylate available from Kyoei Kagaku Kogyo Kabushiki Kaisha
R-684: tricyclodecanedimethylol diacrylate available from NIPPON KAYAKU CO., LTD.
PM-2: ethylene oxide modified dimethacrylate phosphate available from NIPPON KAYAKU CO., LTD.
R-561: phenoxyethyl acrylate available from NIPPON KAYAKU CO., LTD.
THFA: tetrahydrofurfuryl acrylate available from OSAKA
ORGANIC CHEMICAL INDUSTRY LTD.
IRGACURE 184: 1-hydroxycyclohexyl phenyl ketone available from Ciba Specialty Chemicals (photopolymerization initiator)
IRGACURE 651: 2,2-dimethoxy-1,2-diphenylethan-1-one available from Ciba Specialty Chemicals (photopolymerization initiator)
IRGACURE 907: 2-methyl-[4-(methylthio)phenyl]-2-morpholino-1-propanone available from Ciba Specialty Chemicals (photopolymerization initiator)

Each UV-cure adhesive resin composition and bonded optical disk obtained were evaluated according to the following method.

### (1) Electrical resistivity

The electrical resistivity of each UV-cure adhesive resin composition was measured using the aforementioned measuring apparatus. The results are shown in Table 1.

### (2) Generation of voids (air bubbles)

Inclusion of voids (air bubbles) of each bonded optical disk was observed by a microscope. The observation results were assessed as follows and shown in Table 1. G ... No inclusion of voids (air bubbles) found according to microscope observation P ... Inclusion of voids (air bubbles) found according to microscope observation

### (3) Appearance of reflection film before and after durability test

Each bonded optical disk was left in an environment of 80°C and 85%RH for 500 hours and 700 hours. The reflection film was visually observed. The observation results were assessed as follows and shown in Table 1.
G ... Compared to those immediately after adhesion, no change was observed in the total reflection film or the translucent reflection film in the evaluation after 700 hours.
M ... Compared to those immediately after adhesion, no change was observed in the total reflection film or the translucent reflection film in the evaluation after 500 hours, but considerable discoloration or pinholes were found in the total reflection film and the translucent reflection film in the evaluation after 700 hours.
P ... Compared to those immediately after adhesion, considerable discoloration or pinholes were found in the total reflection film and the translucent reflection film in the evaluation after 500 hours.

### (4) Electric signal of optical disk before and after durability test

Each obtained bonded optical disk was left in an environment of 80°C and 85%RH for 700 hours. The electric signal of the bonded optical disk after the durability test was evaluated using a DVD data signal measuring device DVD-2000 made by AECO Ltd.

"System jitter" and "PI error" are electric signals from an optical disk, and the larger the value, the more deteriorated the data retention ability of the bonded optical disk. G ... system jitter of not more than 8.0 and PI error of not more than 250 M ... system jitter of 8.1 to 9.0 and PI error of 251 to 350 P ... system jitter of not less than 9.1 and PI error of not less than 351

### (5) Reflectance of translucent reflection film after leaving under sunlight

Each bonded optical disk was left under conditions of a UV illumination at 340 nm of 0.36 W/m², a black panel temperature of 40°C, a bath temperature of 24°C and a bath humidity of 60%RH for 200 hours using XENON WEATHER-OMETER Ci-4000 made by Atlas Material Testing Technology LLC. The disk was taken out and the reflectance of the silver alloy translucent reflection film was then measured by DVD-2000 made by AECO Ltd.
G ... reflectance of silver alloy translucent reflection film of not less than 18.1%
M ... reflectance of silver alloy translucent reflection film of 18.0 to 17.1%
P ... reflectance of silver alloy translucent reflection film of not more than 17.0%

| Table 1 | Example | | | | | Comparative Example |
|---|---|---|---|---|---|---|
| | 1 | 2 | 3 (*) | 4 | 5 | 1 |
| EPA-37 | 20 | 20 | 20 | 20 | 15 | |
| IRGACURE-184 | | | | | | 4 |
| IRGACURE-651 | 5 | 5 | 5 | 5 | 5 | |
| IRGACURE-907 | | | | 2 | | 2 |
| 4HBA | 10 | | | 10 | 10 | 32 |
| HPA | | 10 | | | | |
| PM-2 | 0.1 | 0.1 | 0.1 | 0.1 | 0.1 | 0.1 |
| R-684 | 50 | 50 | 50 | 50 | 50 | |
| THFA | | | | | | 15 |
| R-561 | 15 | 15 | 15 | 15 | 15 | |
| 4EG-A | | | | | | 13 |
| BP-4EA | | | | | | 8 |
| MANDA | | | 10 | | | |
| UA-732 | | | | | 5 | 41 |
| Viscosity (mPa·s 25°C) | 460 | 460 | 490 | 450 | 470 | 640 |
| (1) Electrical resistivity (MΩ·cm 25°C) | 400 | 300 | 400 | 400 | 530 | 1800 |
| (2) Generation of voids (air bubbles) | G | G | G | G | G | P |
| (3) Appearance of reflection film before and after durability test | G | G | G | G | G | M |
| (4) Electric signal of optical disk before and after durability test | G | G | G | G | G | M |
| (5) Reflectance of translucent reflection film after leaving under sunlight | G | G | G | G | G | P |

| | | | | | | |
|---|---|---|---|---|---|---|
| (*): Reference Example | | | | | | |

### Example 6

A single layer bonded optical disk of the present invention was prepared by adhering two substrates using the UV-cure resin composition of Example 1 according to the following procedures 1 to 4.
1. According to a usual method, a DVD-R pigment layer was formed on a 0.6 mm thick PC substrate on which grooves are formed by a usual method of the DVD-R standard.
2. Silver alloy TTP-40A available from Target Technology Company LLC was sputtered on the substrate on which the pigment layer was formed so that the average film thickness was 55 nm on the DVD-R pigment layer.
3. 2.5 g of the UV-cure resin composition of Example 1 was supplied to the circumference of the silver alloy reflection film of the substrate formed as above in the form of a circle. A 0.6 mm thick PC substrate was put thereon and spin coating was conducted at a rate of 2000 rpm for 4 seconds to bond them so that the film thickness of the UV-cure resin composition was 45 to 65 µm. As an optical disk bonding apparatus, an apparatus made by Origin ELECTRIC CO., LTD. was used.
4. By using upper and lower two xenon flash lamps, irradiation of 8 shots at 1800 V was conducted by the upper lamp and irradiation of 4 shots at 1600 V was conducted by the lower lamp to carry out curing and adhesion. In the irradiation process, the DVD disk was positioned with the 0.6 mm thick PC substrate on the upper side and the silver alloy total reflection film on the lower side.

Each UV-cure adhesive resin composition and bonded optical disk obtained were evaluated according to the following method.

### (1) Electrical resistivity

Measured in the same manner as above.

### (2) Generation of voids (air bubbles)

Measured in the same manner as above.

### (3) Appearance of reflection film before and after durability test

After recording information on the obtained bonded optical disk, it was left in an environment of 80°C and 85%RH for 200 hours and 400 hours. The reflection film was visually observed. The observation results were assessed as follows. G ... Compared to those immediately after adhesion, no change was observed in the total reflection film or the translucent reflection film in the evaluation after 400 hours.
M ... Compared to those immediately after adhesion, no change was observed in the total reflection film or the translucent reflection film in the evaluation after 200 hours, but considerable discoloration or pinholes were found in the total reflection film and the translucent reflection film in the evaluation after 400 hours.
P ... Compared to those immediately after adhesion, considerable discoloration or pinholes were found in the total reflection film and the translucent reflection film in the evaluation after 200 hours.

### (4) Electric signal of optical disk before and after durability test

After recording information on the obtained bonded optical disk, it was left in an environment of 80°C and 85%RH for 200 hours. The electric signal of the bonded optical disk after the durability test was evaluated using a DVD-R data signal measuring device.

"System jitter" and "PI error" are electric signals from an optical disk, and the larger the value, the more deteriorated the data retention ability of the bonded optical disk.
G ... system jitter of not more than 8.0 and PI error of not more than 250
M ... system jitter of 8.1 to 9.0 and PI error of 251 to 350
P ... system jitter of not less than 9.1 and PI error of not less than 351

### (5) Reflectance of translucent reflection film after leaving under sunlight

Measured in the same manner as above.

The results obtained above are as follows.

| | | |
|---|---|---|
| (1) | Electrical resistivity | G |
| (2) | Generation of voids (air bubbles) | G |
| (3) | Appearance of reflection film before and after durability test | G |
| (4) | Electric signal of optical disk before and after durability test | G |
| (5) | Reflectance of translucent reflection film after leaving under sunlight | G |

### Advantages of the Invention

The UV-cure resin composition for bonding an optical disk of the present invention can afford, to a bonded optical disk using a silver or silver alloy translucent reflection film, high reliability equivalent to those of conventional bonded optical disks in which gold is used for a translucent reflection film, can prevent generation of voids in an optical disk manufacturing apparatus, and can suppress degradation in reflectance of the silver or silver alloy translucent reflection film even if a bonded optical disk obtained is exposed to sunlight for a long time. The UV-cure resin composition for bonding an optical disk of the present invention also has an excellent effect on single layer types.

## Claims

1. A UV-curable resin composition for bonding substrates of an optical disk, one or both of which have a total reflection film or a translucent reflection film comprising silver or a silver alloy,
**characterized in that**
the UV-curable resin composition comprises, as essential components, an epoxy (meth) acrylate (A),
2,2-dimethoxy-1,2-diphenylethan-1-one,
a mono- to trifunctional (meth) acrylate monomer (E) other than (A), a monofunctional (meth) acrylate compound (C) containing a hydroxyl group and
a (meth) acrylate phosphate compound (D).

2. The UV-curable resin composition according to claim 1, wherein the mono- to trifunctional (meth) acrylate monomer (E) is dicyclopentanyl di(meth) acrylate.

3. The UV-curable resin composition according to claim 1, wherein the mono- to trifunctional (meth) acrylate monomer (E) is hydroxypivalic acid neopentyl glycol di(meth) acrylate.

4. The UV-curable resin composition according to any one of claims 1 to 3, which has an electrical resistivity of 1000 MΩ·cm (MΩ = 10⁶ Ω) or less at 25°C.

5. A bonded optical disk in which two disk substrates are allowed to adhere with a UV-curable resin composition according to any one of claims 1 to 4.

## Patentansprüche

1. UV-härtbare Harz-Zusammensetzung zum Binden von Substraten einer optischen Disk, wobei eines oder beide einen Totalreflexionsfilm oder einen transluzenten Reflexionsfilm aufweisen, der Silber oder eine Silberlegierung umfasst,
**dadurch** charakterisiert, dass
die UV-härtbare Harz-Zusammensetzung als wesentliche Komponenten umfasst
ein Epoxy(meth)acrylat (A),
2,2-Dimethoxy-1,2-diphenylethan-1-on,
ein von (A) verschiedenes mono- oder trifunktionelles (Meth)acrylatmonomer (E),
eine eine Hydroxylgruppe enthaltende monofunktionelle (Meth)acrylat-Verbindung (C), und
eine (Meth)acrylatphosphat-Verbindung (D).

2. UV-härtbare Harz-Zusammensetzung nach Anspruch 1 , wobei das mono- bis trifunktionelle (Meth)acrylatmonomer (E) Dicyclopentanyldi(meth)acrylat ist.

3. UV-härtbare Harz-Zusammensetzung nach Anspruch 1, wobei das mono- bis trifunktionelle (Meth)acrylatmonomer (E) Hydroxypivalinsäureneopentylglykoldi(meth)acrylat ist.

4. UV-härtbare Harz-Zusammensetzung nach einem der Ansprüche 1 bis 3, welche einen elektrischen Widerstand von 1000 MΩ · cm (MΩ = 10⁶ Ω) oder weniger bei 25°C aufweist.

5. Gebundene optische Disk, in der zwei Disk-Substrate mit einer UVhärtbaren Harz-Zusammensetzung nach einem der Ansprüche 1 bis 4 gebunden sind.

## Revendications

1. Composition de résine durcissable aux UV servant à lier des substrats d'un disque optique, dont l'un ou les deux présentent une couche de- réflexion totale ou une couche de réflexion translucide comprenant de l'argent ou un alliage d'argent,
**caractérisée en ce que** la composition de résine durcissable aux UV comprend, comme composants essentiels,
- un (méth)acrylate époxydique (A),
- une 2,2-diméthoxy-1,2-diphényléthan-1-one,
- un monomère (méth)acrylate allant de mono- à trifonctionnel (E), autre que (A),
- un composé de (méth)acrylate monofonctionnel (C) contenant un groupe hydroxyle et
- un composé de phosphate de (méth)acrylate (D).

2. Composition de résine durcissable aux UV selon la revendication 1, dans laquelle le monomère (méth)acrylate allant de mono- à trifonctionnel (E) est le di(méth)-acrylate de dicyclopentanyle.

3. Composition de résine durcissable aux UV selon la revendication 1, dans laquelle le monomère (méth)acrylate allant de mono- à trifonctionnel (E) est le di(méth)-acrylate de néopentylglycol de l'acide hydroxypivalique.

4. Composition de résine durcissable aux UV selon l'une quelconque des revendications 1 à 3, qui présente une résistivité électrique de 1000 MΩ.cm (MΩ = 10⁶ Ω) ou moins à 25°C.

5. Disque optique lié dans lequel deux substrats de disque sont laissés adhérer avec une composition de résine durcissable aux UV selon l'une quelconque des revendications 1 à 4.
